# EUROPEAN PATENT APPLICATION

(11) **EP 3 345 686 A1**
(43) Date of publication of application: **11.07.2018**
(21) Application number: 17198645.8
(22) Date of filing: 26.10.2017
(51) Int. Cl.: B06B 1/02

(54) **ULTRASONIC TRANSDUCER INTEGRATED WITH SUPPORTING ELECTRONICS**

(30) Priority: 26.12.2016 US 201615390628
(71) Applicant: NXP USA, Inc., Austin TX 78735 (US)
(72) Inventor: ZHANG, Qing, 5656 AG Eindhoven (NL)
(74) Representative: Pomper, Till

(57) **Abstract**

Capacitive micromachined ultrasound transducer (CMUT) module (100) and method for manufacturing the CMUT module are described. The CMUT module includes a CMUT array (104) and an integrated circuit (IC) die (102). The CMUT array includes a CMUT membrane (130), a layer of cells (136) and a plurality of CMUT elements with first metal contacts (142). The CMUT elements are separated by isolation trenches (146) that do not extend into any cavity of the cells (132). The IC die includes second metal contacts (118) that are attached to the first metal contacts of the CMUT elements of the CMUT array by eutectic bonds to provide electrical and structure connections between the CMUT array and the IC die.

## Description

Embodiments of the invention relate generally to ultrasonic transducers and, more particularly, to transducers integrated with supporting electronics and methods for manufacturing such integrated ultrasounds transducers.

Ultrasound transducers, such as capacitive micro-machined ultrasonic transducers (CMUTs) can transmit ultrasonic waves and sense returning ultrasonic waves or echoes to detect objects, which are typically not visible, and measure their distances. Ultrasound transducers are commonly used for medical imaging applications and for nondestructive testing (NDT) of products and structures to detect invisible flaws.

Most ultrasound transducers use piezoelectric elements for sending and sensing ultrasonic waves via piezoelectric transduction. CMUTs, however, use capacitive elements for sending and sensing ultrasonic waves via electrostatic transduction, which require supporting circuits or electronics, e.g., application specific integrated circuits (ASICs).

Recent developments have integrated CMUTs with their supporting electronics, which can greatly simplify the hardware and reduce system size. In addition, since the electronics, such as pre-amplifiers, are built close to the receiving CMUT, signal loss can be significantly reduced. However, there is still a need to improve CMUT fabrication technology, in terms of its integration with electronics and its packaging.

### SUMMARY

Capacitive micromachined ultrasound transducer (CMUT) module and method for manufacturing the CMUT module are described. The CMUT module includes a CMUT array and an integrated circuit (IC) die. The CMUT array includes a CMUT membrane, a layer of cells and a plurality of CMUT elements with first metal contacts. The CMUT elements are separated isolation trenches that do not extend into any cavity of the cells. The IC die includes second metal contacts that are attached to the first metal contacts of the CMUT elements of the CMUT array by eutectic bonds to provide electrical and structure connections between the CMUT array and the IC die.

In an embodiment, a method for manufacturing a CMUT module includes fabricating a CMUT array of the CMUT module, the CMUT array including a CMUT membrane, a layer of cells coupled to the CMUT membrane, at least one of the cells including a cavity, and a plurality of CMUT elements with first metal contacts coupled to the layer of cells, the CMUT elements being separated by isolation trenches that do not extend into any cavity of the cells, obtaining an integrated circuit (IC) with second metal contacts, and attaching the IC with the CMUT array so that the first metal contacts of the CMUT elements of the CMUT array are attached to the second metal contacts of the IC by eutectic bonds to provide electrical and structure connections between the CMUT array and the IC.

In an embodiment, fabricating the CMUT array of the CMUT module includes forming vacuum cells in the layer of cells.

In an embodiment, the first metal contacts of the CMUT array and the second metal contacts of the IC are made of aluminum (Al) and germanium (Ge) so that AlGe eutectic bonds are formed between the CMUT array and the IC.

In an embodiment, the method further comprises forming a coupling layer coupled to the CMUT array, the coupling layer including an opening filled with polymer-based material.

In an embodiment, the method further comprises, prior to attaching the IC with the CMUT array, leaving the isolation trenches unfilled so that the isolation trenches are open spaces.

In an embodiment, fabricating the CMUT array of the CMUT module includes forming standoff posts on the CMUT elements, the first metal contacts being coupled to the standoff posts so that the first metal contacts of the CMUT array are positioned between the standoff posts and the second metal contacts of the IC when the IC is attached to the CMUT array.

In an embodiment, fabricating the CMUT array of the CMUT module includes bonding a first substrate with the layer of cells to a second substrate with the CMUT membrane so the layer of cells and the CMUT membrane are located within a resulting structure.

In an embodiment, bonding the first substrate with the layer of cells with the second substrate includes fusion bonding the first substrate with the layer of cells with the second substrate.

In an embodiment, a CMUT module includes a CMUT array and an IC die. The CMUT array includes a CMUT membrane, a layer of cells coupled to the CMUT membrane, at least one of the cells including a cavity, and a plurality of CMUT elements with first metal contacts coupled to the layer of cells, the CMUT elements being separated by isolation trenches that do not extend into any cavity of the cells. The IC die is attached to the CMUT array. The IC die includes second metal contacts that are attached to the first metal contacts of the CMUT elements of the CMUT array by eutectic bonds to provide electrical and structure connections between the CMUT array and the IC die.

In an embodiment, the cells in the layer of cells are vacuum cells.

In an embodiment, the first metal contacts of the CMUT array and the second metal contacts of the IC die are made of aluminum (Al) and germanium (Ge) so that AlGe eutectic bonds are formed between the CMUT array and the IC die.

In an embodiment, the CMUT module further comprises a coupling layer coupled to the CMUT array, the coupling layer including an opening filled with polymer-based material.

In an embodiment, the isolation trenches are open spaces.

In an embodiment, the CMUT elements of the CMUT array include standoff posts, the first metal contacts being coupled to the standoff posts so that the first metal contacts of the CMUT array are positioned between the standoff posts and the second metal contacts of the IC die when the IC die is attached to the CMUT array.

In an embodiment, the CMUT array includes a first substrate with the layer of cells bonded to a second substrate with the CMUT membrane so the layer of cells and the CMUT membrane are located within the CMUT array.

In an embodiment, a CMUT module includes a CMUT array, an IC die and a coupling layer. The CMUT array includes a CMUT membrane, a layer of cells coupled to the CMUT membrane, at least one of the cells including a cavity, and a plurality of CMUT elements with first metal contacts coupled to the layer of cells, the CMUT elements being separated from by isolation trenches that extend to the layer of cells at locations between the cells so that the isolation trenches do not extend into any cavity of the cells. The IC die is attached to the CMUT array. The IC die includes second metal contacts that are attached to the first metal contacts of the CMUT elements of the CMUT array by eutectic bonds to provide electrical and structure connections between the CMUT array and the IC die. The coupling layer is coupled to the CMUT array. The coupling layer includes an opening filled with polymer-based material.

In an embodiment, the cells in the layer of cells are vacuum cells.

In an embodiment, the first metal contacts of the CMUT array and the second metal contacts of the IC die are made of aluminum (Al) and germanium (Ge) so that AlGe eutectic bonds are formed between the CMUT array and the IC die.

In an embodiment, the isolation trenches are open spaces.

In an embodiment, the CMUT elements of the CMUT array include standoff posts, the first metal contacts being coupled to the standoff posts so that the first metal contacts of the CMUT array are positioned between the standoff posts and the second metal contacts of the IC die when the IC die is attached to the CMUT array.

Other aspects and advantages of embodiments of the present invention will become apparent from the following detailed description, taken in conjunction with the accompanying drawings, depicted by way of example of the principles of the invention.

### BRIEF DESCRIPTION OF THE DRAWINGS

Fig. 1 is a cross-sectional view of a CMUT module in accordance with an embodiment of the invention.
Fig. 2 illustrates CMUT elements of the CMUT module.
Fig. 3 shows a graph of resonant frequency versus width of CMUT cells for 2 micrometer (µm) CMUT membrane and 5 µm CMUT membrane in accordance with an embodiment of the invention.
Figs. 4A-4K illustrate a process of manufacturing the CMUT module in accordance with an embodiment of the invention.
Fig. 5 is a process flow diagram of a method for manufacturing a CMUT module in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment. Thus, the phrases "in one embodiment," "in an embodiment," and similar language throughout this specification may, but do not necessarily, all refer to the same embodiment.

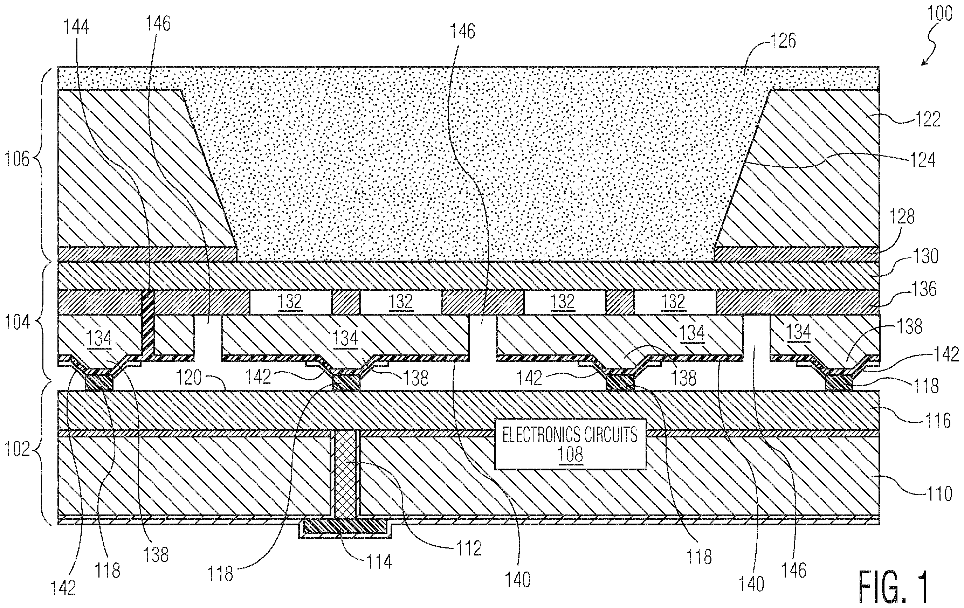

Fig. 1 is a cross-sectional view of a capacitive micro-machined ultrasonic transducer (CMUT) module 100 in accordance with an embodiment of the invention. The CMUT module 100 may be used for various application, including air/gas applications (operation frequency of 500 kilohertz (kHz) to 5 megahertz (MHz)) and immersion applications (operation frequency of 10 kHz to 60 MHz). The air/gas applications may include nondestructive testing (NDT) for inspecting materials for cracks and defects, ranging or proximity sensing (higher the operation frequency, shorter the measurement range) and gas flow rate measurement. The immersion applications may include medical imaging (higher the operation frequency, better the lateral and depth resolution of the imaging, but shorter the imaging range), underwater NDT and liquid level detection. As described in more detail below, the design of the CMUT module 100 integrates transmitting and receiving circuits with CMUTs, which can greatly simplify the hardware and reduce system size. In addition, when the pre-amplifier is built close to the receiving CMUT, signal loss is significantly reduced. The design of the CMUT module 100 also incorporates a coupling layer, which reduces acoustic loss during transmitting and receiving in immersion applications.

In the embodiment depicted in Fig. 1, the CMUT module 100 includes an integrated circuit (IC) die 102, a CMUT array 104 and a coupling layer 106. In this embodiment, the IC die 102 is an application specific integrated circuit (ASIC). The ASIC 102 includes supporting electronic circuits 108 for the CMUT array 104 to send and receive ultrasonic waves. These electronic circuits are formed on a substrate 110, such as a silicon (Si) substrate. The ASIC 102 includes one or more conductive vias 112 that electrically connect one or more surface electrical metal contacts 114 to the electronic circuits 108. As an example, the ASIC 102 includes, but not limited to, actuating and sensing circuits, including pre-amplifiers. The ASIC 102 also includes one or more layers 116 on the substrate 110, which may be used to form the supporting electronic circuits 108. The ASIC 102 further includes metal contacts 118 on a surface 120 of the ASIC facing the CMUT array 104 that are electrically connected to the electronic circuits 108. The metal contacts 118, which may be made of any suitable metal material for eutectic bonding at temperatures within the thermal tolerance of the ASIC 102, such as aluminum (Al), germanium (Ge), gold (Au), or tin (Sn), are used to bond with the CMUT array 104 to provide electrical and structural connections to the CMUT array.

The coupling layer 106 provides insulation and protection for the CMUT module 100 from its environment. In addition, the coupling layer 106 functions to match with the acoustic impedance of surrounding medium of the CMUT module 100. The coupling layer 106 is made of a substrate 122, such a Si substrate, with an opening 124 filled with polymer-based material 126, such as polydimethylsiloxane (PDMS) or polyimide. In the illustrated embodiment, the coupling layer 106 includes a buried oxide layer 128, which is adjacent to the CMUT array 104.

The CMUT array 104 operates to send and sense ultrasonic waves using a CMUT membrane 130, which may be made of doped Si or poly-Si. As used herein, "doped" means that an element, such as Si, is doped with appropriate material, i.e., dopant, to make the element conductive. The CMUT array 104 includes cavities or cells 132 formed between the CMUT membrane 130 and CMUT elements 134 in a buried oxide layer 136, which may be referred to herein as a layer of cells. In an embodiment, these cells 132 are vacuum cells or cavities. Each of the CMUT elements 134 is configured to have a standoff post 138, which is covered by a layer 140 of doped poly-Si and metal contacts 142. In an embodiment, the metal contacts 142 of the CMUT array 104 are bonded with the metal contacts 118 of the ASIC 102 to form eutectic bonds. Thus, the metal contacts 142 of the CMUT array 104 are made of material suitable to create eutectic bonds, such as Al, Ge, Au or Sn. The eutectic bonds between the CMUT array 104 and the ASIC 102 provide hermetic sealing to the back of CMUT array (the front of the CMUT array is covered with the coupling layer 106), so that the CMUT module 100 can be used in immersion applications where the surrounding medium is liquid. The CMUT array 104 also includes one or more conductive vias 144 that electrically connect at least one of the metal contacts 142 to the CMUT membrane 130.

The CMUT array 104 further includes isolation trenches 146 between the CMUT elements 134. Thus, the CMUT elements 134 are separated from each other by the isolation trenches 146, which extend to the buried oxide layer 136 at locations between the cells 132. However, the isolation trenches 146 do not extend into any of the cells 132. In the illustrated embodiment, the isolation trenches 146 are not filled with any solid material, and thus are voids or open spaces in the CMUT module 100, which makes the fabrication process simpler. These isolation trenches 144 do not have to be vacuum spaces. In other embodiments, the isolation trenches 144 may be filled with any appropriate material.

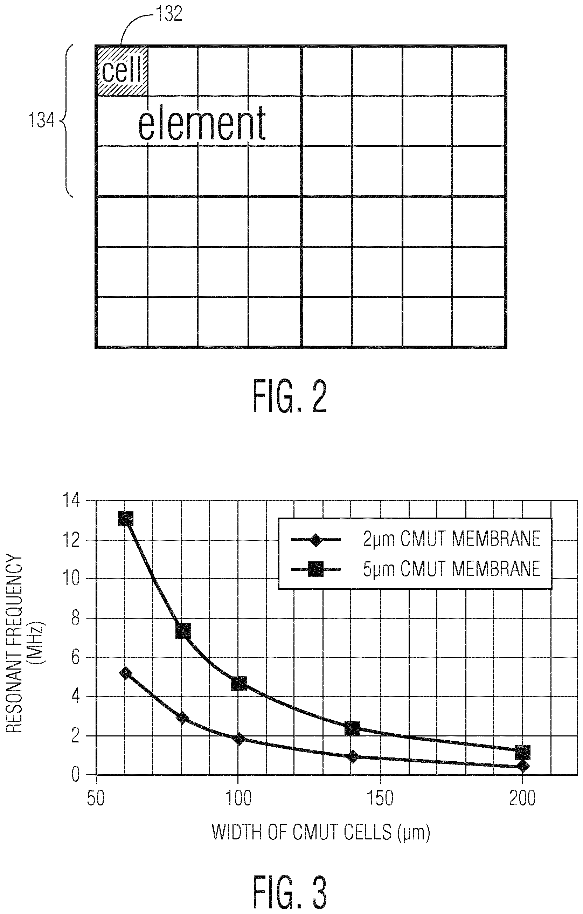

In an embodiment, the CMUT elements 134 form a two-dimensional CMUT array 104, as illustrated in Fig. 2. As shown in Fig. 2, each of the CMUT elements 134 include an array of cells 132. In this illustrated example, each of the CMUT elements 134 includes a 4×3 array of cells 132. However, in other embodiments, the CMUT array 104 may include any number of CMUT elements arranged according to the application, each of which includes any number of cells.

Each CMUT element 134 of the CMUT module 100 is addressable using signals applied to the metal contacts 142 via the metal contacts 118 by the ASIC 102. The CMUT membrane 130 acts as a ground plane. To send ultrasonic waves, signals are selectively applied to the metal contacts 142 on the CMUT elements 134 by the ASIC 102 to causes electrostatic actuation, which induces the CMUT membrane 130 to vibrate, sending ultrasonic waves through the coupling layer 106. To sense ultrasonic waves, changes in capacitance in the cells 132 as the CMUT membrane 130 vibrates due to ultrasonic waves received at the CMUT membrane are detected by the ASIC 102 as alternating signals through the metal contacts 118 and 142.

The resonant frequency of the CMUT module 100 using poly-Si as the material for the CMUT membrane 130 can be tuned easily by varying the thickness of the CMUT membrane and the width of the cells 132. Thus, the actual device geometries of the CMUT module 100 will be determined by the working frequency required in the application. The relationship between the resonant frequency to the thickness of the CMUT membrane 134 and the width of the cells 132 is illustrated in Fig. 3, which shows a graph of the resonant frequency versus thickness of CMUT cells for 2 micrometer (µm) CMUT membrane and 5 µm CMUT membrane. Using the graph of Fig. 3, to achieve 2 MHz resonant frequency, the membrane diameter should be ∼150 um for a 5 um thick poly-Si membrane.

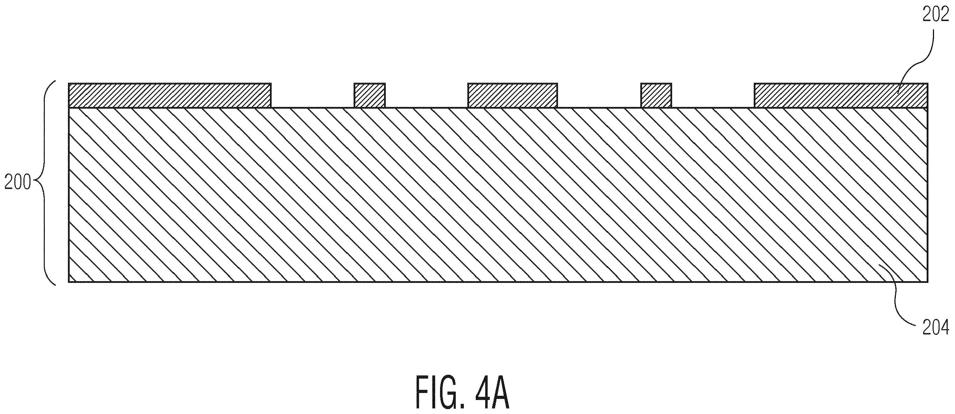

A process of manufacturing the CMUT module 100 in accordance with an embodiment of the invention is described with reference to Figs. 4A-4K. As illustrated in Fig. 4A, a first substrate 200 is prepared by growing an oxidation layer 202 on a doped layer 204, which may be a Si wafer. The oxidation layer 202 is then etched to form the oxidation layer 136 of the CMUT module 100. Thus, the oxidation layer 202 will be referred to as the oxidation layer 136 in subsequent figures. As an example, the oxidation layer 202 may be approximately 200 nanometers (nm) in thickness. As used herein, the term "approximately" means plus or minus ten (10) percent. As explained below, the doped layer 204 is used to form the CMUT elements 134 of the CMUT module 100.

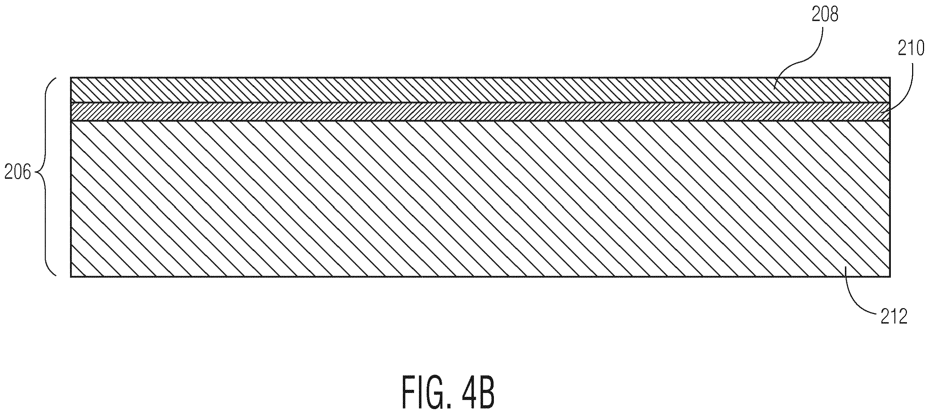

Next, as illustrated in Fig. 4B, a second substrate 206 composed of a doped Si layer 208, a buried oxide layer 210 and a handle wafer 212 is prepared. The doped Si layer 208 is used as the CMUT membrane 130, and thus will be referred to as the CMUT membrane. The handle wafer 212 is used to form the substrate 122 of the coupling layer 106 of the CMUT module 100.

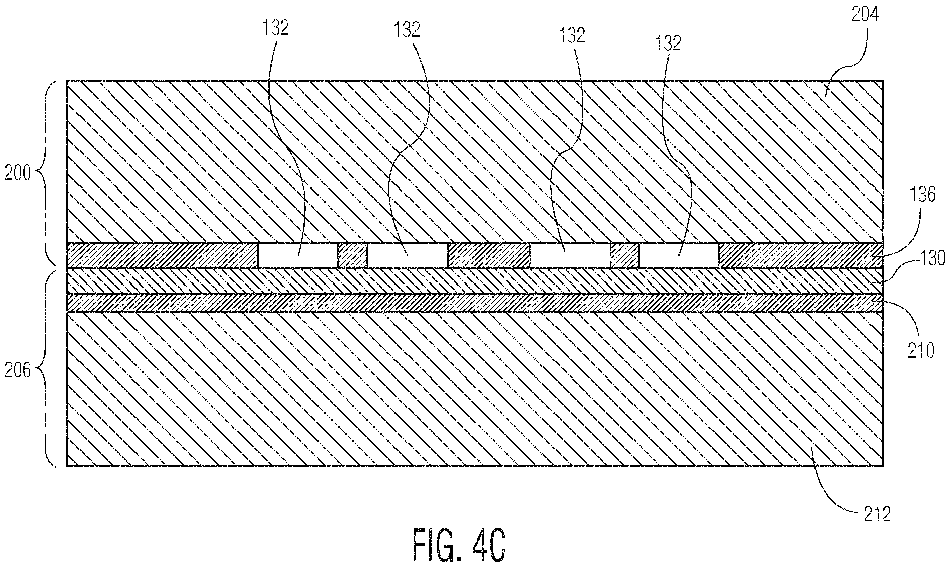

Next, as illustrated in Fig. 4C, the first and second substrates 200 and the 206 are bonded to form the vacuum cavities or cells 132 of the CMUT module 100. In an embodiment, the two substrates 200 and 206 are fusion-bonded.

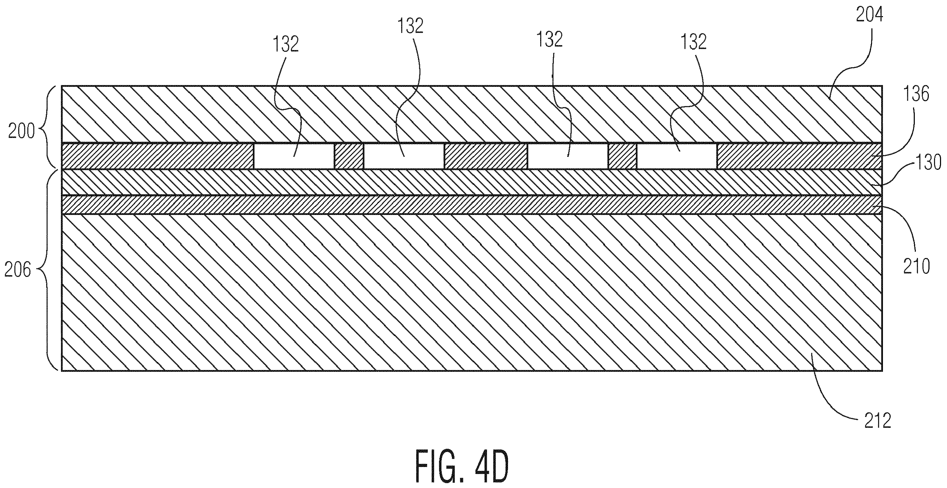

Next, as illustrated in Fig. 4D, the doped layer 204 of the first substrate 200 is thinned down. As an example, the doped layer 204 may be thinned down using mechanical grinding and chemical and mechanical polishing or other etching techniques.

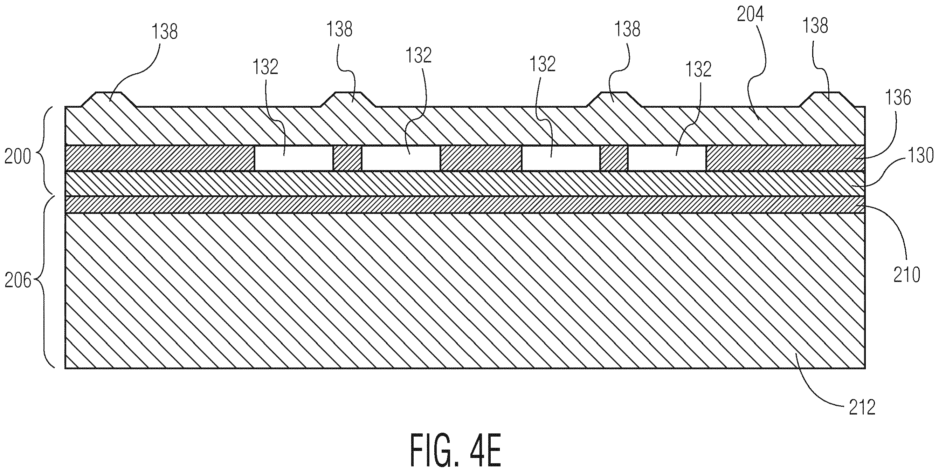

Next, as illustrated in Fig. 4E, the standoff posts 138 are formed on the doped layer 204. As an example, the standoff posts 138 may be formed by etching away some of the top surface of the doped layer 204.

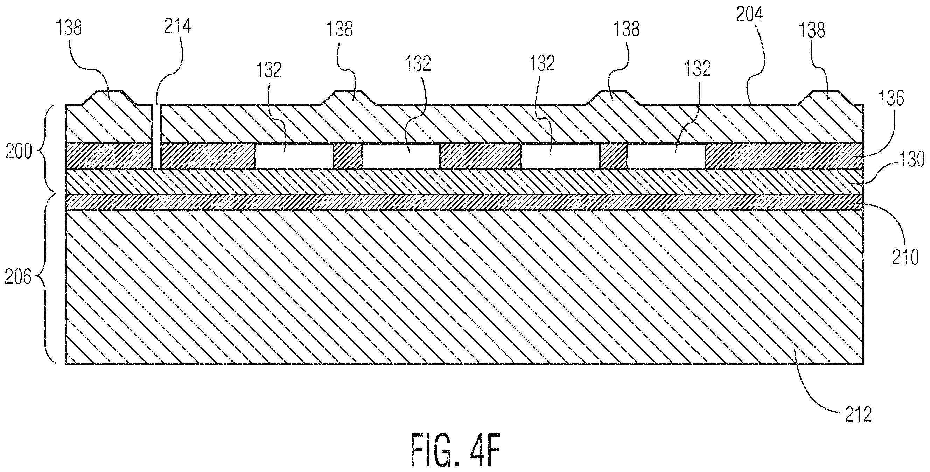

Next, as illustrated in Fig. 4F, an opening 214 is formed through the doped layer 204 and the oxidation layer 136 of the first substrate. In an embodiment, the opening 214 is formed by etching through the doped layer 204 and the underlying oxidation layer 136 and stopping on the CMUT membrane 130, which is a doped Si layer.

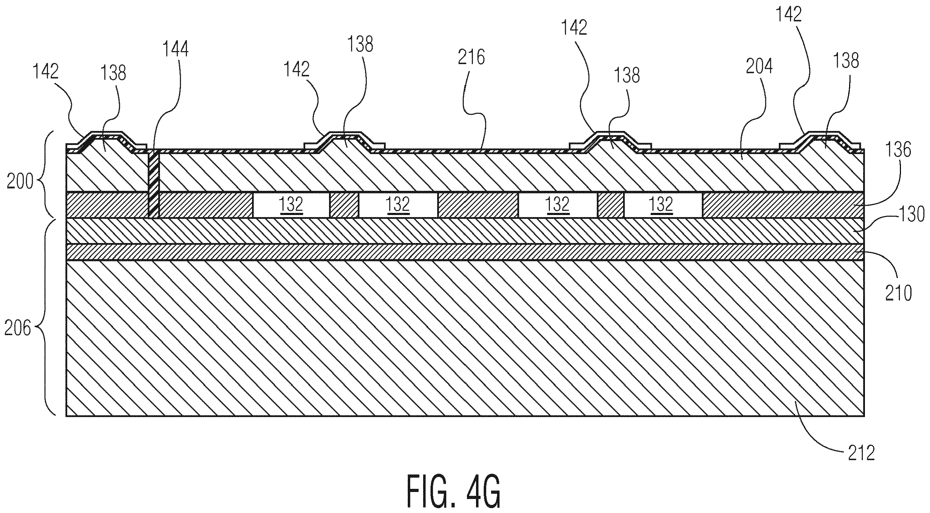

Next, as illustrated in Fig. 4G, a blanket layer 216 of doped poly-Si is deposited on the doped layer 204 to completely fill the opening 214, which forms the conductive via 144. In addition, a metal layer is deposited on the blanket layer 216 and then patterned to form the metal contacts 142. As an example, the deposited metal layer may be a layer of Ge to form Ge metal contacts.

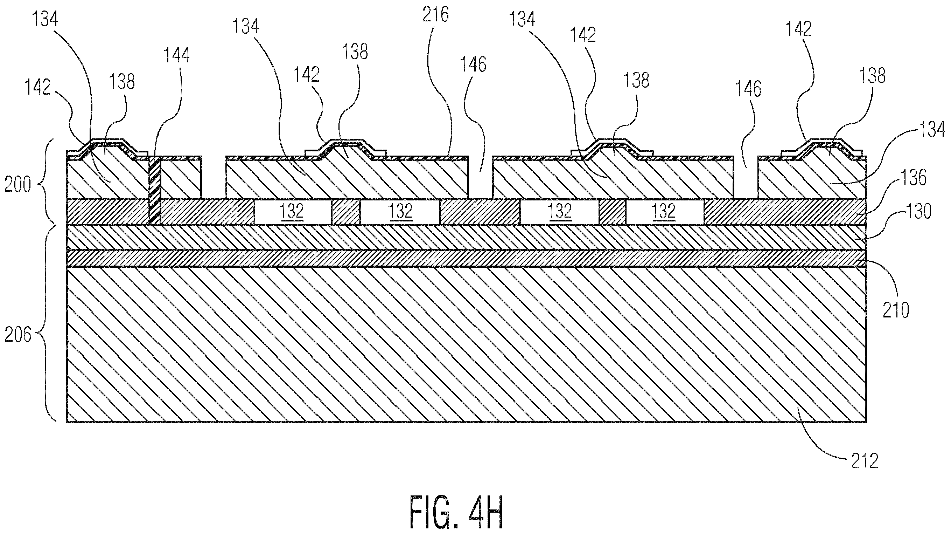

Next, as illustrated in Fig. 4H, the isolation trenches 146 are formed through the blanket layer 216 and the doped layer 204, which form the CMUT elements 134. In an embodiment, the isolation trenches 146 are formed by etching away portions of the blanket layer 216 and the doped layer 204 and stopping on the buried oxide layer 136. The first substrate 200 with the CMUT membrane 130 will now be referred to as the CMUT array 104. The second substrate 206 without the CMUT membrane 130 will now be referred to as the coupling layer 106. In addition, the blanket layer 216 will now be referred to as the doped poly-Si layer 140.

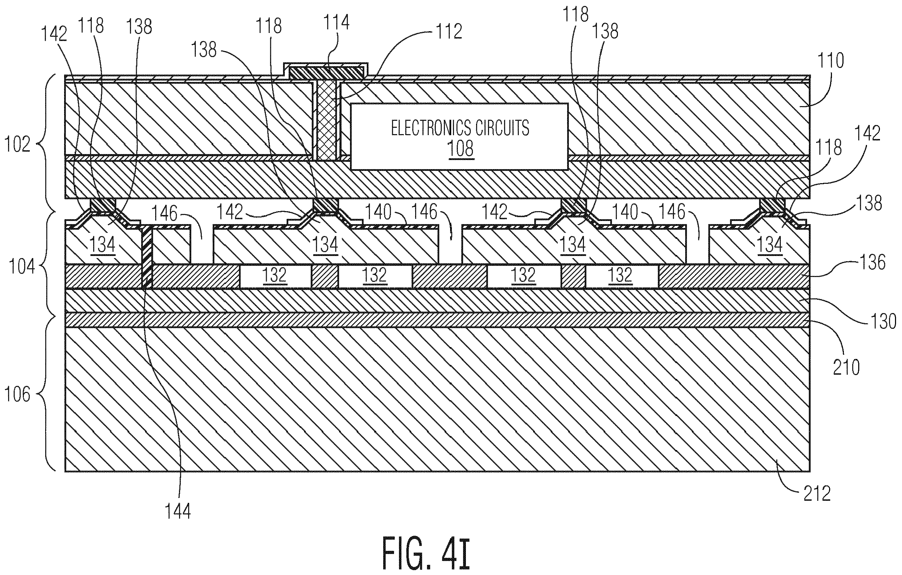

Next, as illustrated in Fig. 4I, the ASIC 102 is structurally and electrically connected to the CMUT array 104. In particular, the metal contacts 118 of the ASIC 102 are attached to the metal contacts 142 on the standoff posts 138 using a eutectic bonding process to form eutectic bonds between the corresponding metal contacts. The bonding process is pressure-controlled in order to maintain a hermetic environment within the sealed space between the CMUT array 104 and the ASIC 102. In a particular implementation, the metal contacts 118 of the ASIC 102 are made of Al and the metal contacts 142 on the standoff posts 138 are made of Ge to form Al-Ge eutectic bonds. The bonded substrate goes through a series of process in order to fabricate conductive vias 112 that electrically connect one or more surface electrical metal contacts 114 to the electronic circuits 108.

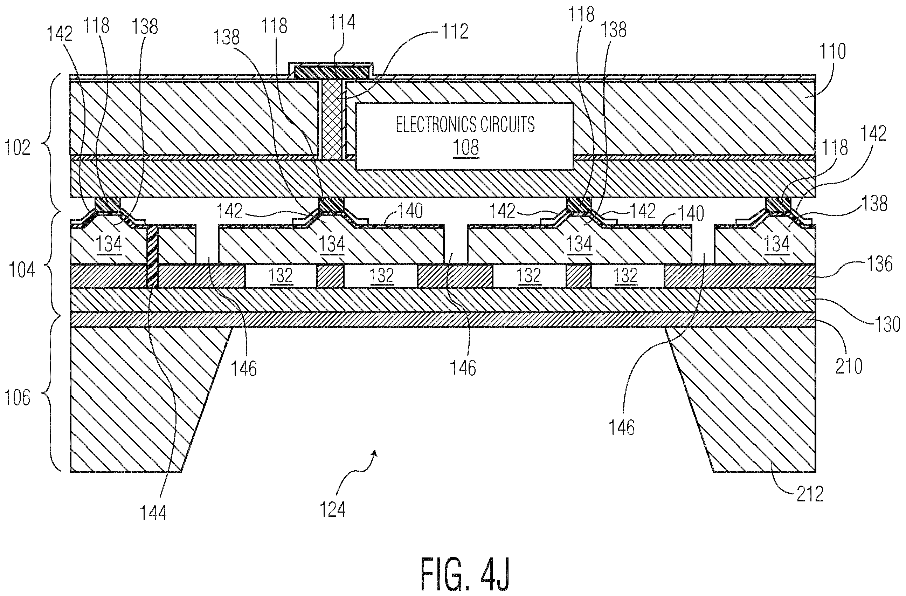

Next, as illustrated in Fig. 4J, the opening 124 is made in the handle wafer 212. In an embodiment, the opening 124 is made in the handle wafer 212 using deep reactive-ion etching (DRIE) or wet etching to expose the active area and etch stops on the buried oxide layer 210. The handle wafer 212 will now be referred to as the substrate 122 of the coupling layer 106 of the CMUT 100. After the creation of the opening 124, the exposed oxide layer 210 is removed by, for example, etching. The remaining oxide layer 210 will now be referred to as the buried oxide layer 128 of the coupling layer 106 of the CMUT 100.

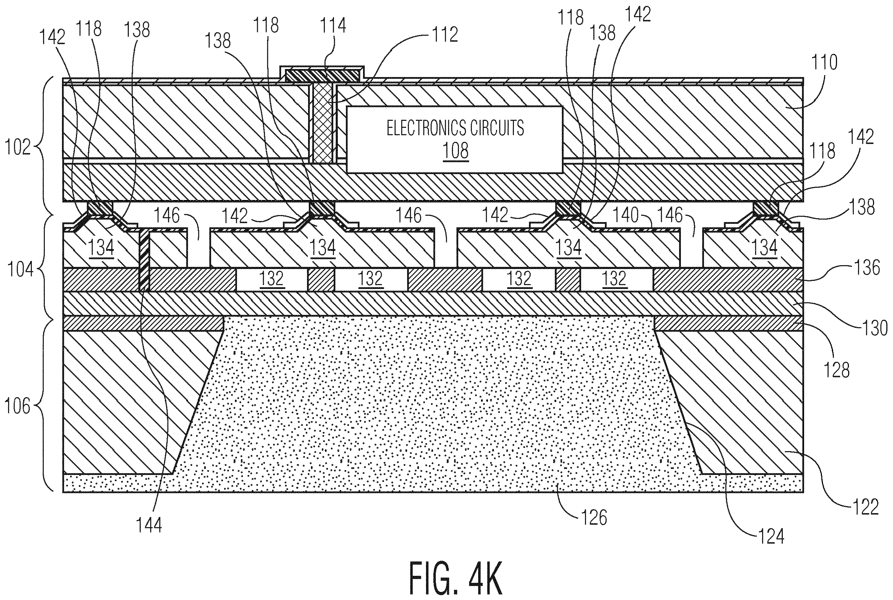

Next, as illustrated in Fig. 4K, the polymer-based material 126 is applied to the substrate 122, filling the opening 124 with the polymer-based material 126 and forming a coating on the substrate 122. In an embodiment, polymer-based material 126 is spin-coated on the backside of the structure onto the substrate 122 to completely fill the opening 124 and to form a coating on the substrate 122. The completed device shown in Fig. 4K is same as the CMUT module 100 shown in Fig. 1 that has been flipped upside down.

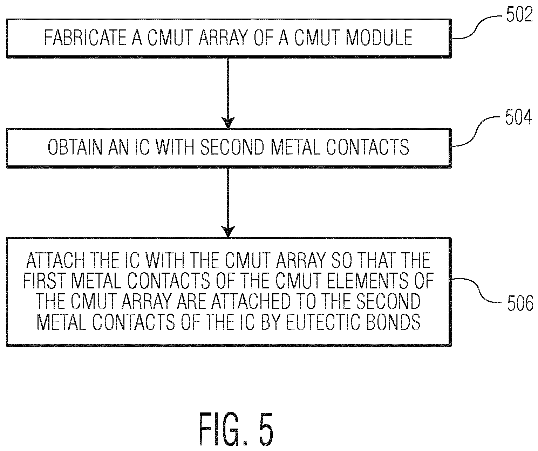

Fig. 5 is a process flow diagram of a method for manufacturing a CMUT module in accordance with an embodiment of the invention. At block 502, a CMUT array of the CMUT module is fabricated. The CMUT array includes a CMUT membrane, a layer of cells coupled to the CMUT membrane, at least one of the cells including a cavity, and a plurality of CMUT elements with first metal contacts coupled to the layer of cells. The CMUT elements are separated by isolation trenches that do not extend to any cavity of the cells. Next, at block 504, an integrated circuit (IC) with second metal contacts is obtained. Next, block 506, the IC is attached with the CMUT array so that the first metal contacts of the CMUT elements of the CMUT array are attached to the second metal contacts of the IC by eutectic bonds to provide electrical and structure connections between the CMUT array and the IC.

Although the operations of the method herein are shown and described in a particular order, the order of the operations of the method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

In addition, although specific embodiments of the invention that have been described or depicted include several components described or depicted herein, other embodiments of the invention may include fewer or more components to implement less or more feature.

Furthermore, although specific embodiments of the invention have been described and depicted, the invention is not to be limited to the specific forms or arrangements of parts so described and depicted. The scope of the invention is to be defined by the claims appended hereto and their equivalents.

## Claims

1. A method for manufacturing a capacitive micromachined ultrasound transducer, CMUT, module, the method comprising:
fabricating a CMUT array (104) of the CMUT module (100), the CMUT array (104) including a CMUT membrane (130), a layer of cells (136) coupled to the CMUT membrane (130), at least one of the cells including a cavity (132), and a plurality of CMUT elements (134) with first metal contacts (142) coupled to the layer of cells (136), the CMUT elements (134) being separated by isolation trenches (146) that do not extend into any cavity (132) of the cells;
obtaining an integrated circuit, IC, (102) with second metal contacts (118); and
attaching the IC (102) with the CMUT array (104) so that the first metal contacts (142) of the CMUT elements (134) of the CMUT array (104) are attached to the second metal contacts (118) of the IC (102) by eutectic bonds to provide electrical and structure connections between the CMUT array (104) and the IC (102).

2. The method of claim 1, wherein fabricating the CMUT array (104) of the CMUT module (100) includes forming vacuum cells in the layer of cells (136).

3. The method of claim 1 or claim 2, wherein the first metal contacts (142) of the CMUT array (104) and the second metal contacts (118) of the IC (102) are made of aluminum, Al, and germanium, Ge, so that AlGe eutectic bonds are formed between the CMUT array (104) and the IC (102).

4. The method of any one of the claims 1 to 3, further comprising forming a coupling layer (106) coupled to the CMUT array (104), the coupling layer (106) including an opening filled with polymer-based material (126).

5. The method of any one of the claims 1 to 4, prior to attaching the IC (102) with the CMUT array (104), leaving the isolation trenches (146) unfilled so that the isolation trenches (146) are open spaces.

6. The method of any one of the claims 1 to 5, wherein fabricating the CMUT array (104) of the CMUT module (100) includes forming standoff posts (138) on the CMUT elements (134), the first metal contacts (142) being coupled to the standoff posts (138) so that the first metal contacts (142) of the CMUT array (104) are positioned between the standoff posts (138) and the second metal contacts (118) of the IC (102) when the IC (102) is attached to the CMUT array (104).

7. The method of any one of the claims 1 to 6, wherein fabricating the CMUT array (104) of the CMUT module (100) includes bonding a first substrate (200) with the layer of cells (136) to a second substrate (206) with the CMUT membrane (130) so the layer of cells (136) and the CMUT membrane (130) are located within a resulting structure.

8. The method of claim 7, wherein bonding the first substrate (200) with the layer of cells (136) with the second substrate (206) includes fusion bonding the first substrate (200) with the layer of cells (136) with the second substrate (206).

9. A capacitive micromachined ultrasound transducer, CMUT, module comprising:
a CMUT array (104) including:
a CMUT membrane (130);
a layer of cells (136) coupled to the CMUT membrane (130), at least one of the cells including a cavity (132); and
a plurality of CMUT elements (134) with first metal contacts (142) coupled to the layer of cells (136), the CMUT elements (134) being separated from by isolation trenches (146) that do not extend into any cavity (132) of the cells; and
an IC die (102) attached to the CMUT array (104), the IC die (102) including second metal contacts (118) that are attached to the first metal contacts (142) of the CMUT elements (134) of the CMUT array (104) by eutectic bonds to provide electrical and structure connections between the CMUT array (104) and the IC die (102).

10. The CMUT module of claim 9, wherein the cells in the layer of cells (136) are vacuum cells.

11. The CMUT module of claim 9 or claim 10, wherein the first metal contacts (142) of the CMUT array (104) and the second metal contacts (118) of the IC die (102) are made of aluminum, Al, and germanium, Ge, so that AlGe eutectic bonds are formed between the CMUT array (104) and the IC die (102).

12. The CMUT module of any one of the claims 9 to 11, further comprising a coupling layer (106) coupled to the CMUT array (104), the coupling layer (106) including an opening filled with polymer-based material (126).

13. The CMUT module of any one of the claims 9 to 12, wherein the isolation trenches (146) are open spaces.

14. The CMUT module of any one of the claims 9 to 13, wherein the CMUT elements (134) of the CMUT array (104) include standoff posts (138), the first metal contacts (142) being coupled to the standoff posts (138) so that the first metal contacts (142) of the CMUT array (104) are positioned between the standoff posts (138) and the second metal contacts (118) of the IC die (102) when the IC die (102) is attached to the CMUT array (104).

15. The CMUT module of any one of the claims 9 to 14, wherein the CMUT array includes a first substrate (200) with the layer of cells (136) bonded to a second substrate (206) with the CMUT membrane (130) so the layer of cells (136) and the CMUT membrane (130) are located within the CMUT array (104).
